Europäisches Patentamt

European Patent Office

Office européen des brevets

(19)

(11) Publication number: **0 116 304 B1**

(12) **EUROPEAN PATENT SPECIFICATION**

(45) Date of publication of patent specification: **17.04.91** (51) Int. Cl.⁵: **H01L 31/12**

(21) Application number: **84100337.9**

(22) Date of filing: **13.01.84**

(54) **Composite optical semiconductor device.**

(30) Priority: **14.01.83 JP 3359/83**
 **28.04.83 JP 73802/83**

(43) Date of publication of application:
 **22.08.84 Bulletin 84/34**

(45) Publication of the grant of the patent:
 **17.04.91 Bulletin 91/16**

(84) Designated Contracting States:
 **DE FR GB**

(56) References cited:
 **DE-A- 3 106 798**
 **GB-A- 2 094 060**
 **US-A- 4 136 928**
 **US-A- 4 275 404**

 **PATENT ABSTRACTS OF JAPAN, vol. 6, no. 99 (E-111)[977], 8th June 1982 & JP-A-57 30 384**

(73) Proprietor: **KABUSHIKI KAISHA TOSHIBA**
 **72, Horikawa-cho Saiwai-ku**
 **Kawasaki-shi Kanagawa-ken 210(JP)**

(72) Inventor: **Nakanura, Masaru c/o Patent Division**
 **Tokyo Shibaura Denki K.K. 72, Horikawa-cho Saiwai-ku Kawasaki-shi Kanagawa-ken(JP)**
 Inventor: **Nitsuta, Kouichi c/o Patent Division**
 **Tokyo Shibaura Denki K.K. 72, Horikawa-cho Saiwai-ku Kawasaki-shi Kanagawa-ken(JP)**
 Inventor: **Ozeki, Takeshi c/o Patent Division**
 **Tokyo Shibaura Denki K.K. 72, Horikawa-cho Saiwai-ku Kawasaki-shi Kanagawa-ken(JP)**

(74) Representative: **Blumbach Weser Bergen Kramer Zwirner Hoffmann Patentanwälte Radeckestrasse 43 W-8000 München 60(DE)**

**Description**

This invention relates to a composite optical semiconductor device including a light emitting element and a light detecting element in one body.

A light emitting diode (LED) has such an output characteristic that the fluctuation dependent on the temperature is smaller than that of a semiconductor laser device. The output characteristic is more linear. A LED is a source of light easy to deal with except for the problems of power level and response speed. But, if the LED is actually used in ananalog transmission system, nevertheless the fluctuation of its output characteristic must be compensated. Nowadays, a wideband opto-electric negative feedback (NFB) loop is widely used for compensating both the fluctuation dependent or the temperature and the nonlinearity at the same time as explained in the paper MJ2 of I00C '81, San Francisco in U.S.A. (1981). In the wideband opto-electric NFB loop, nonlinear distortion of the LED is compensated by a negative feedback of a part of a light output to a driver circuit of the LED after detecting the part of the light output of the LED. Then it is desirable to construct in a body a light emitting element and a light detecting element in order to compensate the nonlinear distortion.

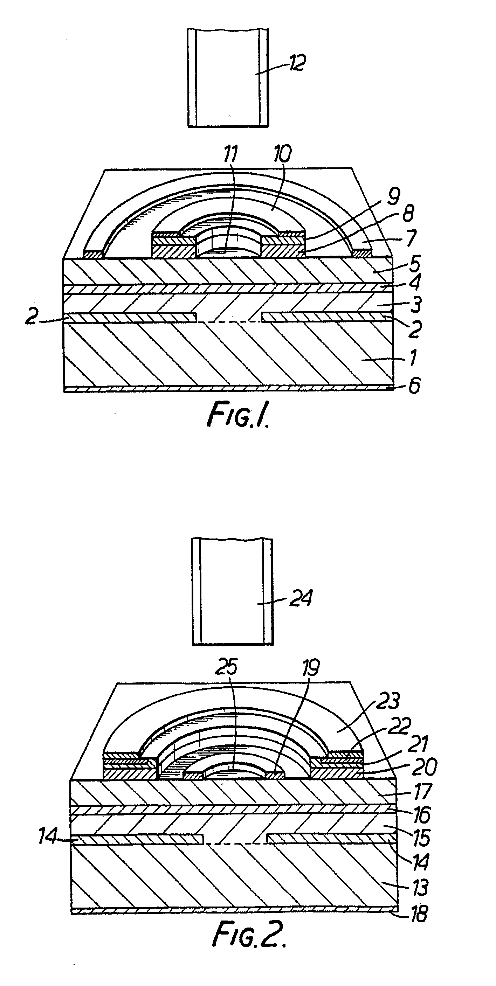

A prior art composite optical semiconductor device, which includes in a body a LED and a photo detector (PD), is shown in Figure 1; this device corresponds to that of the preamble of claim 1. In the prior art device, the LED is constructed as follows. A P-type GaAlAs layer 3 is formed on a N-type GaAs current confinement layer 2 which is formed on a P-type GaAs substrate 1. The P-type layer 3 penetrates the current confinement layer 2 in the center area thereof. A N-type GaAlAs layer 5 is formed on a N-type GaAs active layer 4 which is formed on the P-type layer 3. The LED emits a light in the active layer 4 by applying a voltage between a first electrode 6 and a second electrode 7. A PD comprises the N-type GaAlAs layer 5, a GaAlAs intrinsic layer 8 and a P-type GaAs layer 9. As the GaAlAs layer 8 detecting a light of the LED has a low impurity concentration, the PD has a P-I-N construction. The PD is operated by applying a voltage between a third electrode 10, formed on the P-type GaAs layer 9, and said second electrode 7. Namely, the N-type GaAlAs layer 5 and the electrode 7 are used in common in the LED and the PD. In this structure, a light emitted from the active layer 4 is detected by the PD and is transmitted to the outside through a light transmitting portion 11 which is formed in the center of the device. The light output from the transmitting portion 11 enters into an optical fibre 12. And the electrical output of the PD supplies an outside electrical circuit which is part of a wideband opto-electric NFB loop in order to control a driver circuit of the LED.

In the wideband opto-electric NFB loop, it is necessary to get an exact monitoring current dependent on the light of the LED which passes the PD. The PD detects this part of the light output of the LED. But it is difficult to get a correct monitoring current in the prior art device. Because in the prior art device, the electrode 7 is used in common for the LED and for the PD and is constructed outside of the detecting portion of the PD, the current path of the LED is close to that of the PD, and both paths partly overlap each other. Therefore, a leak current flows from the LED to the PD, and the PD may detect a wrong monitoring current of the light of the LED.

DE-A-3 106 798 discloses a circuit structure including an integrated light emitting diode and a FET in which a middle portion of a layer of the structure constitutes the drain of the FET as well as a portion of the diode. Using a common electrode there result overlapping current paths for both the diode and the drain zone of the FET.

It is the problem underlying the invention to provide a composite optical semiconductor device in which a current path of a light emitting element does not overlap with that of a light detecting element and in which the light detecting element can get a correct monitoring current of the light emitting element.

This problem is solved by the features defined in claim 1.


BRIEF DESCRIPTION OF THE DRAWINGS

A more complete appreciation of the invention and many of the attendant advantages thereof will be readily obtained as the same becomes better understood by reference to the following detailed description when considered in connection with the accompanying drawings, wherein

Figure 1 shows a diagrammatic view, partly in section, of a prior art composite optical semiconductor device;

Figure 2 shows a diagrammatic view, partly in section, of a preferred embodiment of this invention;

Figures 3 to 5 show further embodiments of this invention.


DESCRIPTION OF THE PREFERRED EMBODIMENT

Referring now to the drawings, wherein like reference numerals designate identical or corresponding parts throughout the several views, and more particularly to Figure 2 thereof, one embodiment of this invention is explained.

In the first embodiment, a P-type GaAs substrate 13 is used as a substrate of a LED. The substrate 13 has impurities of a concentration of $1 \times 10^{18}$ cm$^{-3}$ and a thickness of 100 to 200 $\mu$m. A current confinement layer 14 is formed on the substrate 13 and is provided with a window in order to concentrate the current of the LED and to get a high light emitting efficiency. The confinement layer 14 is made of N-type GaAs having impurities of a concentration of $1 \times 10^{18}$ cm$^{-3}$ and a thickness of 4 to 5 $\mu$m. A first component layer 15 is formed within the area of the window of the confinement layer 14 on the substrate 13 and on the current confinement layer 14. The first component layer 15 is made of P-type $Ga_{1-x}Al_xAs$ having impurities of a concentration of $1 \times 10^{18}$ cm$^{-3}$ and the thickness of 4 to 5 $\mu$m, wherein x is 0.3 to 0.4. An active layer 16 is formed on the first component layer 15. The active layer 16 is made of N-type GaAs having impurities of a concentration of $1 \times 10^{18}$ cm$^{-3}$ and a thickness of 1 $\mu$m. A second component layer 17 is formed on the active layer 16. The second component layer 17 is made of N-type $Ga_{1-x}Al_xAs$ having impurities of a concentration of $1 \times 10^{18}$ cm$^{-3}$ and a thickness of 5 $\mu$m, wherein x is 0.3 to 0.4. In this structure, light is emitted in the active layer 16 by applying a voltage between a first electrode 18 and a second electrode 19. The electrodes 18 and 19 are made of metal.

As a part of a PD, a GaAlAs layer 20 is formed circularly on a part of said N-type layer 17, the latter being used as a component of the PD and also as the second component layer 17 of the LED. The GaAlAs layer 20 has impurities of low concentration as it is used for an intrinsic layer and has a thickness of about 10 $\mu$m. A P-type GaAs layer 21 is formed on the GaAlAs layer 20. The GaAs layer 21 has a thickness of 3 $\mu$m and impurities of a concentration of $1 \times 10^{18}$ cm$^{-3}$. A P-type GaAs layer 22 is formed in the P-type GaAs layer 21 in order to have a good ohmic contact with a third electrode 23 made of metal.

The P-type GaAs layer 22 has impurities more than that of the P-type GaAs layer 21. The PD can be operated by applying a voltage between the third electrode 23 and a second electrode 19 which is also the second electrode 19 of the LED. The electrode 19 has a width of about 30 $\mu$m and is formed circularly inside of and spaced from the detecting portion i.e. the intrinsic layer 20 of the PD. The detecting portion of the PD has a width of about 50 $\mu$m to 70 $\mu$m.

In this structure, part of the light output from the active layer 16 of the LED is detected by the PD and a part of the light output enters an optical fibre 24 through a light transmitting portion 25 which is inside and outside of the nontransparent electrode 19. At the same time, the electrical output of the PD is led to an outside electrical circuit, part thereof being a wideband opto-electric NFB loop. In this case, the electrode 19, which is commonly used for the LED and for the PD, is formed inside of the photo detecting portion, and has generally earth voltage. Therefore the current paths of the LED and the PD are separated from each other sufficiently and do not overlap each other, and a leak current from the LED to the PD is prevented. The PD detects the correct monitoring current of the LED.

In this embodiment, the electrode 19 may be formed triangularly, squarely, polygonaly or elliptically instead of circularly. But the efficiency of the light output must be considered because the electrode is generally made of nontransparent material.

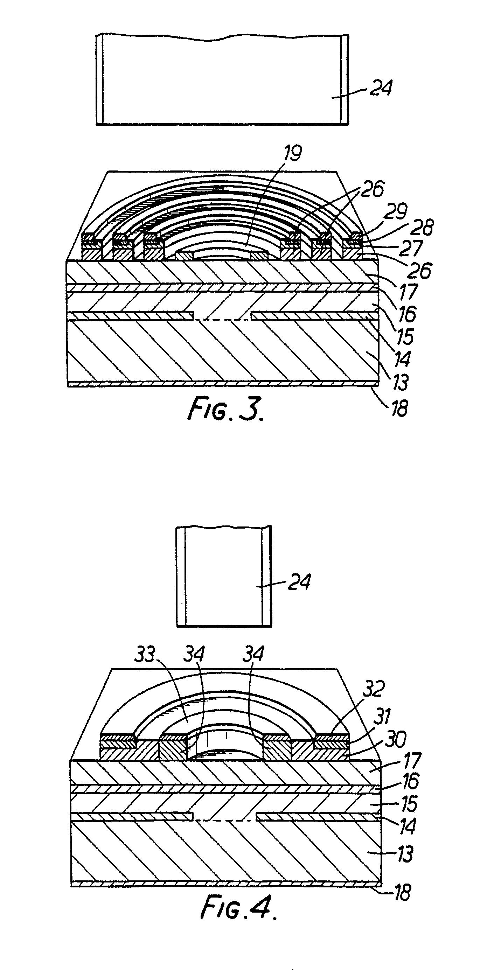

Another embodiment is shown in Figure 3. A LED is formed similarly to the first embodiment according to Fig. 2. But in this case the PD has a plurality of detecting portions. Namely, the detecting portion of the PD according to the first embodiment is divided into plural parts arranged concentrically on the second component layer 17. The PD includes three concentric GaAlAs layers 26, which have impurities of low concentration, P-type GaAs layers 27, P-type GaAs layers 28 for good ohmic contact, and third electrodes 29. The plural detecting portions are formed with concentric circles outside of the second electrode 19 which is also one of the electrodes of the LED. The third electrodes 29 of the PD are short circuited by one another and connected to earth voltage. In this structure, the light output from the LED enters also an optical fibre 24. The non-linear characteristic of the light of the center is generally different from that of the light of the periphery. According to this embodiment the optical fibre 24 receives the light from the entire surface of the device. At the same time, a part of the light is detected by the photo detecting portions 26 and the PD monitors the light of the LED more correctly. As the photo detecting portions 26 are divided into plural parts, compared with the device according to Fig. 2, sufficient light from the LED enters the optical fibre 24.

Another embodiment is shown in Figure 4. In this embodiment a LED is formed similar to the first embodiment according to Fig. 2. A PD is formed on a second component layer 17 of the LED. A GaAlAs layer 30, which has impurities of a low concentration, is formed on part of the N-Type layer 17 and a P-type GaAs layer 31 is formed thereon. The PD has also a P-I-N structure and can be operated by a voltage between a third electrode 32 and a second electrode 33. The second electrode is connected to the N-type layer 17 through a N-type region 34, the concentration of impurities thereof being higher than the concentration of impurities of the N-type layer 17. The second electrode 33 of the PD is also one of the electrodes of the LED. In this structure the light output from the LED enters an optical fibre 24 similarly as in the embodiment according to Fig. 2 and is detected and monitored by the PD and the outside circuit at the same time. It is easy to align a mask in a manufacturing step producing this embodiment. Namely, the electrodes 19 of the first and second embodiments must be formed on the depressed portions after having formed the PD, but the electrode 33 of this embodiment can be formed easily and precisely on the P-type region 34.

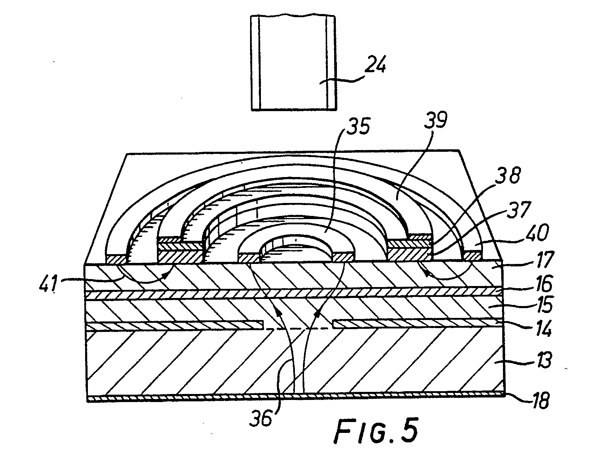

Still another embodiment is shown in Figure 5. A LED of this embodiment is formed similarly to the first embodiment according to Fig. 2. The LED emits a light from an active layer 16 by applying a voltage between a first electrode 18 and a second electrode 35. A current path 36 of the LED is confined to the center by a current confinement layer 14. A PD comprises a GaAs intrinsic layer 37 and a P-type GaAs layer 38 which are formed on a N-type layer 17. This layer is the second component layer 17 of the LED. The PD can be operated by applying a voltage between a third electrode 39 and a fourth electrode 40. The fourth electrode 40 is formed circularly outside of and spaced from the photo detecting portion i.e. the intrinsic layer 37. A current path 41 of the PD is formed between the third and fourth electrodes 39 and 40. This current path is formed apart from the current path 36 of the LED between the first and second electrodes 18 and 35. Namely, the current path 41 of the PD is independent of the current path 36 of the LED. Therefore, a leak current from the LED to the PD is reduced to a neglectable amount, and the PD detects the correct monitoring current. It is effective to form the current paths of the LED and the PD independently, and then the leak current from the LED to the PD can be reduced to less than 1 % of the detecting current of the PD.

## Claims

1. A composite optical semiconductor device including a light emitting element and a light detecting element comprising:

a first semiconductor region (13/15;) having first conductivity type (P-type) formed in a semiconductor substrate, a second semiconductor region (17) having second conductivity type (N-type) and together with the first region forming the light emitting element comprising a PN junction,

a current confinement layer (14) with an aperture formed in the first or second region (13/15 or 17),

a first electrode (18) connected to the first region (13/15),

a second electrode (19, 33; 35) connected to the second region (17),

a light transmitting portion (25) transmitting light emitted by applying a voltage between the first and second electrodes,

a third semiconductor region (20/21/22; 26/27/28; 30/31; 37/38) forming together with the second region (17) the light detecting element detecting a part of the emitted light,

a third electrode (23; 29; 32; 39) connected to the third region,

a fourth electrode (19, 33; 40) connected to the second region,

characterized in that the light detecting element is formed around the light emitting element and the light transmitting portion (25) is formed at the center portion of the second electrode (19, 33, 35) and that the third region (20/21/22; 26/27/28; 37/38) is formed around the second electrode (19, 33; 35), such that the main current path between the third and the fourth electrodes (23; 29; 32; 39, 19, 33; 40) is formed substantially independently of a main current path between the first and the second electrodes (18, 19, 33; 35).

2. A composite optical semiconductor device according to claim 1, wherein the second electrode (19; 33) is identical with the fourth electrode.

3. A composite optical semiconductor according to claim 2, wherein the third region (20/21/22; 26/27/28; 30/31) and the third electrode (23; 29; 32) are formed annularly, and wherein the second electrode (19; 33) is arranged inside thereof in the area of the light transmitting portion (25).

4. A composite optical semiconductor device according to claim 3, wherein the third region and the third electrode are formed as circular rings.

5. A composite optical semiconductor device according to claim 3 or 4, wherein the third region (26/27/28) comprises a plurality of concentric rings spaced from each other and arranged around the second electrode (19) and wherein the third electrodes (29) are connected to each of the third regions.

6. A composite optical semiconductor device according to any of claims 1 to 5, wherein the third region has the first conductivity type (P-type).

7. A composite optical semiconductor device according to any of claims 1 to 6, wherein the third region comprises an intrinsic layer (20; 26; 30; 37) adjacent to the second region.

8. A composite optical semiconductor device according to claim 7, wherein an optical fibre (24) is arranged above the area determined by the aperture of the current confinement layer (14).

9. A composite optical semiconductor device according to claim 1, further comprising a fourth semiconductor region (34) formed adjacent to the third region (30/31) with the same conductivity type (N-type) as the second region (17), and wherein the second electrode (33) is formed on the fourth region (34).

10. A composite optical semiconductor device according to claim 1, wherein the first region is formed in the second region.

11. A composite optical semiconductor device according to claim 1, wherein the third region is formed on the second region.

12. A composite optical semiconductor device according to any of claims 1 to 11, further comprising an active layer (16) formed between the first region (13/15) and the second region (17).

13. A composite optical semiconductor device according to any of claims 1 to 12, further comprising a control circuit for a wideband optoelectric negative feedback loop formed in or on the semiconductor substrate.

**Revendications**

1. Dispositif semiconducteur optique composite comprenant un élément gui émet de la lumière et un élément qui détecte la lumière, ce dispositif comportant :
une première région semiconductrice (13/15) ayant un premier type de conductivité (type P) formée dans un substrat semiconducteur, une seconde région semiconductrice (17) ayant un second type de conductivité (type N) et formant avec la première région l'élément qui émet de la lumière, cet élément comprenant une jonction PN ;

une couche de confinement du courant (14) présentant une ouverture formée dans la première ou dans la seconde région (13/15 ou 17), une première électrode (18) connectée à la première région (13/15) ;
une seconde électrode (19, 33 ; 35) connectée à la seconde région (17) ;
une partie qui transmet de la lumière (25), cette partie transmettant la lumière émise du fait de l'application d'une tension entre les première et seconde électrodes ;
une troisième région semiconductrice (20/21/22 ; 26/27/28 ; 30/31 ; 37/38) formant avec la seconde région (17) l'élément qui détecte la lumière, cet élément détectant une partie de la lumière émise ;
une troisième électrode (23 ; 29 ; 32 ; 39) connectée à la troisième région ; et
une quatrième électrode (19, 33 ; 40) connectée à la seconde région ;
caractérisé en ce que l'élément qui détecte la lumière est formé autour de l'élément qui émet de la lumière, en ce que la partie qui transmet la lumière (25) est formée au niveau de la partie centrale de la seconde électrode (19, 33, 35) et en ce que la troisième région (20/21/22 ; 26/27/28 ; 37/38) est formée autour de la seconde électrode (19, 33 ; 35), de sorte que la voie de courant principal entre les troisième et quatrième électrodes (23 ; 29 ; 32 ; 39, 19, 33 ; 40) soit formée de manière sensiblement indépendante d'une voie de courant principale située entre les première et seconde électrodes (18, 19, 33 ; 35).

2. Dispositif semiconducteur optique composite selon la revendication I, dans lequel la seconde électrode (19 ; 33) est identique à la quatrième électrode.

3. Dispositif semiconducteur optique composite selon la revendication 2, dans lequel la troisième région (20/21/22 ; 26/27/28 ; 30/31) et la troisième électrode (23 ; 29 ; 32) ont une forme annulaire et dans lequel la seconde électrode (19 ; 33) est disposée à l'intérieur des troisième région et troisième électrode, dans la surface de la partie (25) qui transmet la lumière.

4. Dispositif semiconducteur optique composite selon la revendication 3, dans lequel la troisième région et la troisième électrode ont une forme de bague circulaire.

5. Dispositif semiconducteur optique composite selon la revendication 3 ou 4, dans lequel la troisième région (26/27/28) comprend une pluralité de bagues concentriques espacées les unes des autres et disposées autour de la seconde électrode (19) et dans lequel les troisièmes électrodes (29) sont connectées à chacune des troisièmes régions.

6. Dispositif semiconducteur optique composite selon l'une quelconque des revendications 1 à 5, dans lequel la troisième région a le premier type de conductivité (type P).

7. Dispositif semiconducteur optique composite selon l'une quelconque des revendications 1 à 6, dans lequel la troisième région comprend une couche intrinsèque (20 ; 26 ; 30 ; 37) adjacente à la seconde région.

8. Dispositif semiconducteur optique composite selon la revendication 7, dans lequel une fibre optique (24) est disposée au-dessus de la zone déterminée par l'ouverture ménagée dans la couche de confinement du courant (14).

9. Dispositif semiconducteur optique composite selon la revendication 1, comprenant en outre une quatrième région semiconductrice (34) formée de manière adjacente à la troisième région (30/31), cette quatrième région ayant le même type de conductivité (type N) que la seconde région (17), et dans lequel la seconde électrode (33) est formée sur la quatrième région (34).

10. Dispositif semiconducteur optique composite selon la revendication 1, dans lequel la première région est formée dans la seconde région.

11. Dispositif semiconducteur optique composite selon la revendication 1, dans lequel la troisième région est formée sur la seconde région.

12. Dispositif semiconducteur optique composite selon l'une quelconque des revendications 1 à 11, comprenant en outre une couche active (16) formée entre la première région (13/15) et la seconde région (17).

13. Dispositif semiconducteur optique composite selon l'une quelconque des revendications 1 à 12, comprenant en outre un circuit de contrôle pour une boucle à contre-réaction opto-électrique à large bande formée dans ou sur le substrat semiconducteur.

**Ansprüche**

1. Optisches Kombinations-Halbleiterbauelement mit einem lichtemittierenden Element und einem Lichtdetektorelement, umfassend:
   eine in einem Halbleitersubstrat ausgebildete erste Halbleiterzone (13/15) eines ersten Leitungstyps (P-Typ), eine zweite Halbleiterzone (17) vom zweiten Leitungstyp (N-Typ), die zusammen mit der ersten Zone das einen PN-Übergang aufweisende lichtemittierende Element bildet,
   eine Stromeingrenzungsschicht (14) mit einer in der ersten oder der zweiten Zone (13/15 oder 17) ausgebildeten Öffnung,
   eine an die erste Zone (13/15) angeschlossene erste Elektrode (18),
   eine an die zweite Zone (17) angeschlossene zweite Elektrode (19, 33; 35),
   einen lichtaussendenden Abschnitt (25), der Licht aussendet, welches durch Anlegen einer Spannung zwischen die erste und die zweite Elektrode emittiert wird,
   eine dritte Halbleiterzone (20/21/22, 26/27/28; 30/31; 37/38), die zusammen mit der zweiten Zone (17) das Lichtdetektorelement bildet, welches einen Teil des emittierten Lichts detektiert,
   eine dritte Elektrode (23; 29; 32; 39), die an die dritte Zone angeschlossen ist,
   eine an die zweite Zone angeschlossene vierte Elektrode (19, 33; 40), dadurch **gekennzeichnet**, daß das Lichtdetektorelement um das lichtemittierende Element herum ausgebildet und der lichtaussendende Abschnitt (25) im Mittelabschnitt der zweiten Elektrode (19, 33, 35) ausgebildet ist, und daß die dritte Zone (20/21/22; 26/27/28; 37/38) um die zweite Elektrode herum (19, 33; 35) ausgebildet ist, so daß der Hauptstrompfad zwischen der dritten und der vierten Elektrode (23; 29; 32; 39, 19, 33; 40) im wesentlichen unabhängig von einem Hauptstromweg zwischen der ersten und der zweiten Elektrode (18, 19, 33; 35) gebildet ist.

2. Bauelement nach Anspruch 1, bei dem die zweite Elektrode (19; 33) identisch mit der vierten Elektrode ist.

3. Bauelement nach Anspruch 2, bei dem die dritte Zone (20/21/22; 26/27/28; 30/31) und die dritte Elektrode (23; 29; 32) ringförmig ausgebildet sind, während die zweite Elektrode (19; 33) im Inneren davon in der Fläche des lichtaussendenden Abschnitts (25) angeordnet ist.

4. Bauelement nach Anspruch 3, bei dem die dritte Zone und die dritte Elektrode als Kreisringe ausgebildet sind.

5.  Bauelement nach Anspruch 3 oder 4, bei dem die dritte Zone (26/27/28) mehrere konzentrische, voneinander beabstandete und um die zweite Elektrode (19) herum angeordnete Ringe aufweist, und die dritten Elektroden (29) an jede der dritten Zonen angeschlossen sind.

6.  Bauelement nach einem der Ansprüche 1 bis 5, bei dem die dritte Zone vom ersten Leitungstyp (P-Typ) ist.

7.  Bauelement nach einem der Ansprüche 1 bis 6, bei dem die dritte Zone eine eigenleitende Schicht (20; 26; 30; 37) in der Nachbarschaft der zweiten Zone aufweist.

8.  Bauelement nach Anspruch 7, bei dem eine optische Faser (24) oberhalb des durch die Öffnung in der Stromeingrenzungsschicht (14) definierten Flächenbereichs angeordnet ist.

9.  Bauelement nach Anspruch 1, **gekennzeichnet** durch eine vierte Halbleiterzone (34), die benachbart der dritten Zone (30/31) vom gleichen Leitungstyp (N-Typ) wie die zweite Zone (17) ausgebildet ist, und die zweite Elektrode (33) auf der vierten Zone (34) gebildet ist.

10. Bauelement nach Anspruch 1, bei dem die erste Zone in der zweiten Zone ausgebildet ist.

11. Bauelement nach Anspruch 1, bei dem die dritte Zone auf der zweiten Zone gebildet ist.

12. Bauelement nach einem der Ansprüche 1 bis 11, **gekennzeichnet** durch eine zwischen der ersten Zone (13/15) und der zweiten Zone (17) ausgebildete aktive Schicht (16).

13. Bauelement nach einem der Ansprüche 1 bis 12, **gekennzeichnet** durch eine Steuerschaltung für eine breitbandige optoelektrische Gegenkopplungsschleife, die in oder auf dem Halbleitersubstrat ausgebildet ist.

FIG.1.

FIG.2.

FIG. 3.

FIG. 4.

FIG.5